# EUROPEAN PATENT APPLICATION

(11) **EP 2 402 481 A1**
(43) Date of publication of application: **04.01.2012**
(21) Application number: 10167753.2
(22) Date of filing: 29.06.2010
(51) Int. Cl.: C23C 14/34, G02B 1/11, G02F 1/133, H01L 31/18, G06F 3/044

(54) **Method and system for manufacturing a transparent body for use in a touch panel**

(71) Applicant: Applied Materials, Inc., Santa Clara, CA 95054 (US)
(72) Inventor: Lotz, Hans-Georg, 63584, Gründau-Rothenbergen (DE)
(74) Representative: Zimmermann & Partner

(57) **Abstract**

A process for manufacturing a transparent body for use in a touch panel is provided. The process includes: depositing a first transparent layer stack over a substrate with a first dielectric film, a second dielectric film, and a third dielectric film. The first and the third dielectric films have a low refractive index and the second dielectric film has a high refractive index. The process further includes depositing a transparent conductive film in a manner such that the first transparent layer stack and the transparent conductive film are disposed over the substrate in this order. At least one of the first dielectric film, the second dielectric film, the third dielectric film, or the transparent conductive film is deposited by sputtering of a rotatable target. Further thereto, a deposition apparatus for manufacturing a transparent body for use in a touch panel and a transparent body for use in a touch panel are provided.

## Description

### TECHNICAL FIELD

Embodiments of the present disclosure relate to processes and systems for manufacturing a transparent body for use in a touch panel and a transparent body fabricated according to these processes.

### BACKGROUND ART

Touch panels are a particular class of electronic visual displays, which are able to detect and locate a touch within a display area. Generally, touch panels include a transparent body disposed over a screen and configured to sense a touch. Such a body is substantially transparent, so that light in the visible spectrum emitted by the screen can be transmitted therethrough. At least some known touch panels include a transparent body constituted by a barrier and a transparent conductor formed, in this order, over a substrate. A touch on the display area of such a panel generally results in a measurable change of capacitance in a region of the transparent body. The change in capacitance may be measured using different technologies, so that the position of the touch can be determined.

A transparent body for use with a touch panel is subject to some particular requirements. In particular, one key requirement is that the transparent body is stable enough for withstanding multiple contacts on the screen and harsh conditions, so that reliability of the touch screen is not compromised over time. However, at least some known transparent bodies included in touch screens which are considered robust interfere with a proper transmission of light therethrough due to, for example, thickness, composition, and structure of the layers forming the transparent body. Furthermore, fabricating such a stable transparent body with high quality, for example with a uniform and defect-free barrier, is challenging.

Accordingly, it is desirable a process and an apparatus for forming a high-quality transparent body for use in a touch panel in a manner such that the body is stably formed over the substrate without compromising a proper transmission of light in the visible spectrum.

### SUMMARY OF THE INVENTION

In one aspect, a process for manufacturing a transparent body for use in a touch panel is provided. The process includes depositing a first transparent layer stack over a substrate with a first dielectric film, a second dielectric film, and a third dielectric film. The first and the third dielectric films have a low refractive index and the second dielectric film has a high refractive index. The process further includes depositing a transparent conductive film in a manner such that the first transparent layer stack and the transparent conductive film are disposed over the substrate in this order. At least one of the first dielectric film, the second dielectric film, the third dielectric film, or the transparent conductive film is deposited by sputtering of a rotatable target.

In another aspect, a deposition apparatus for manufacturing a transparent body for use in a touch panel is provided. The apparatus includes: a first deposition assembly configured to deposit a first transparent layer stack over a substrate, the first transparent layer stack including a first dielectric film, a second dielectric film, and a third dielectric film, the first and the third dielectric films having a low refractive index and the second dielectric film having a high refractive index; and a second deposition assembly configured to deposit a transparent conductive film. The first deposition assembly and the second deposition assembly are arranged such that the first transparent layer stack and the transparent conductive film are disposed over the substrate in this order. At least one of the first deposition assembly or the second deposition assembly includes a sputtering system operatively coupled to a rotatable target. The sputtering system is configured to deposit at least one of the first dielectric film, the second dielectric film, the third dielectric film, or the transparent conductive film by sputtering of the rotatable target.

According to yet another aspect, a transparent body produced by a process according to the present disclosure is provided. The transparent body includes: a first transparent layer stack over a substrate, the first transparent layer stack including a first dielectric film, a second dielectric film, a third dielectric film; and a transparent conductive film. The first transparent layer stack and the transparent conductive film are disposed over the substrate in this order. The first and the third dielectric films have a low refractive index and the second dielectric film has a high refractive index.

Surprisingly, the combination of dielectric films deposited according to embodiments of the present disclosure having additional dielectric films in comparison to at least some known transparent bodies for use in a touch panel, with a characteristic combination of refractive indexes, and in which at least one of the films is deposited by sputtering of a rotatable target, facilitates manufacturing of a high-quality transparent body that not only yields proper transmission of light but also yields stable performance over time.

Further aspects, advantages, and features of the present invention are apparent from the dependent claims, the description, and the accompanying drawings.

Embodiments are also directed to apparatuses for carrying out the disclosed processes and including apparatus parts for performing described process steps. Furthermore, embodiments are also directed to methods by which the described apparatus operates or by which the described apparatus is manufactured. The methods may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

A full and enabling disclosure, including the best mode thereof, to one of ordinary skill in the art, is set forth more particularly in the remainder of the specification, including reference to the accompanying figures, wherein:

Fig. 1 is a schematic representation of an exemplary transparent body for use in a touch panel in accordance with embodiments herein;

Fig. 2 is a schematic representation of an exemplary deposition apparatus for manufacturing of a transparent body for use in a touch panel in accordance with embodiments herein;

Fig. 3 is a schematic representation of another exemplary deposition apparatus for manufacturing of a transparent body for use in a touch panel in accordance with embodiments herein;

Fig. 4 is a graph illustrating the reflectance of a known transparent body for use in a touch panel;

Fig. 5 is a graph illustrating the reflectance of an exemplary transparent body for use in a touch panel in accordance with embodiments herein;

Fig. 6 is a graph with a direct comparison of reflectances shown in Figs. 4 and 5;

Fig. 7 shows graphs illustrating b* values of a transparent body with the structure of the know transparent body of Fig. 4 and a transparent body with the structure of the exemplary transparent body of Fig. 5;

Fig. 8 shows a graph illustrating b* values of a transparent body with the structure of the exemplary transparent body of Fig. 5;

Fig. 9 shows different graphs evidencing stable performance of a transparent body manufactured according to embodiments herein; and

Fig. 10 is a flow chart illustrating an exemplary process for manufacturing a transparent body for use in a touch panel suitable.

### DETAILED DESCRIPTION OF THE INVENTION

Reference will now be made in detail to the various embodiments, one ore more examples of which are illustrated in the figures. Each example is provided by way of explanation, and is not meant as a limitation of the invention. It is contemplated that elements of one embodiment may be advantageously utilized in other embodiments without further recitation.

The embodiments described herein include a process for manufacturing a transparent body for use in a touch panel. In particular, embodiments of the present disclosure include a transparent body including a first transparent stack configured to constitute a barrier in a touch panel and a transparent conductive film configured to constitute a transparent conductor in a touch panel. Thereby, a transparent body according to embodiments herein facilitates touch sensing when implemented in a touch panel.

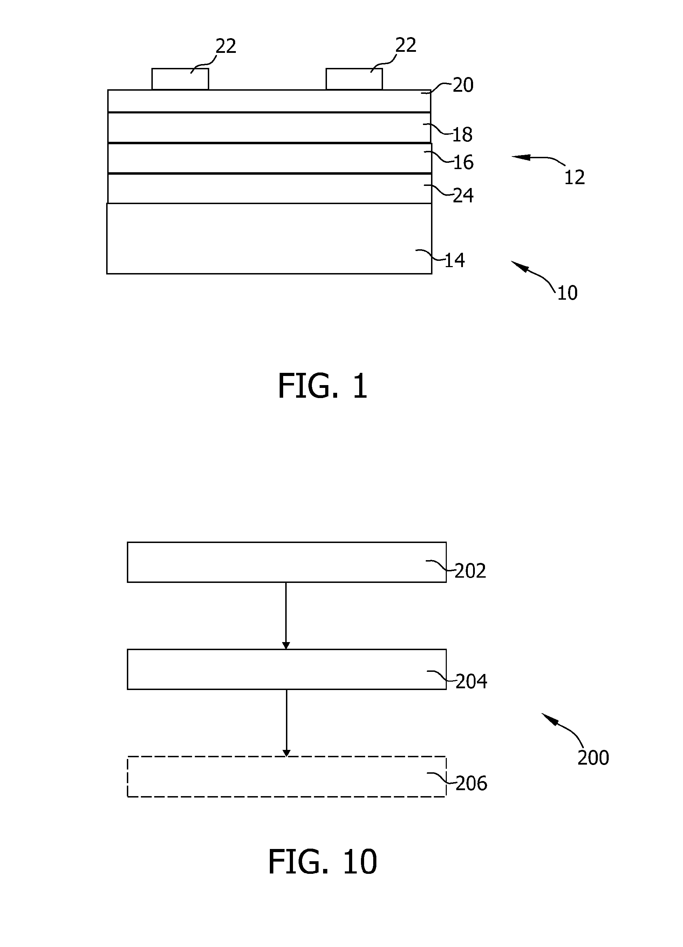

According to embodiments herein, a first transparent layer stack 12, as depicted in Fig. 1, is deposited over a substrate 14. The term "substrate" as used herein shall embrace both inflexible substrates, e.g., a wafer or a glass plate, and flexible substrates such as a web or a foil. The term "transparent" as used herein shall particularly include the capability of a structure to transmit light with relatively low scattering, so that, for example, light transmitted therethrough can be seen in a substantially clearly manner. In the case of a flexible substrate, it is typical that substrate 14 has a hardcoat 24 formed thereon.

According to typical embodiments, a layer stack is constituted by a number of films formed (e.g., by deposition) one atop another. In particular, embodiments herein include depositing a first transparent layer stack which may be constituted by a plurality of dielectric films, that is, films that, substantially, do not conduct electricity. In particular, first transparent layer stack 12 may include a first dielectric film 16, a second dielectric film 18, and a third dielectric film 20, as exemplarily depicted in Fig. 1. Thereby, the first transparent layer stack may constitute a barrier for use in a touch panel. According to typical embodiments, first dielectric film 16, second dielectric film 18, and third dielectric film 20 are deposited one atop each other in this order.

According to embodiments described herein, the first and the third dielectric films have a low refractive index and the second dielectric film has a high refractive index. More specifically, according to embodiments herein, the materials of the first transparent layer stack are chosen in a manner such that the first and third dielectric films have a low refractive index and the second dielectric film has a high refractive index. For example, the first and third dielectric films may consist of a silicon oxide, such as SiO₂, and the second dielectric film may consist of a titanium oxide, such as TiO₂, or a niobium oxide, such as Nb₂O₅.

More specifically, according to embodiments herein, the first and the third dielectric films have a lower refractive index than the second dielectric film. A first transparent layer stack of a transparent body manufactured according to embodiments herein provides, in view of the additional dielectric films in comparison to at least some known transparent bodies for use in a touch panel and the characteristic combination of films with different refractive indexes, a barrier that facilitates a proper transmission of light through the transparent body.

As used herein, a low refractive index is a refractive index sufficiently low for enabling a particular transparent body to transmit light in a manner adequate for a particular application thereof. As used herein, a high refractive index is a refractive index sufficiently high for enabling a particular transparent body to transmit light in a manner adequate for a particular application thereof According to certain embodiments, a low refractive index is a refractive index lower than 1.50. According to certain embodiments, a high refractive index is a refractive index of at least 1.80. In general, the refractive indexes of the dielectric films of the first transparent layer stack is chosen in a manner such that light is transmitted through the transparent body according to embodiments of the present disclosure. For example, the first and the third dielectric films may have a refractive index lower than 1.50 or, more specifically, 1.47 or, even more specifically, 1.45, and the second dielectric films may have a refractive index of at least 1.80 or, more specifically, 2.10, or, even more specifically, 2.40. The values of the refractive index listed in the present disclosure refer to refraction of green light at a wavelength of 515 nm.

According to embodiments described herein, transparent body 10 includes a transparent conductive film 22, such as, but not limited to, indium tin oxide (ITO), in particular, crystalline ITO or ITO with a sheet resistance of 400 Ohm/square. According to typical embodiments, as exemplarily depicted in Fig. 1, deposition is performed in a manner such that a first transparent layer stack 12 and transparent conductive film 22 are disposed over a substrate 14 in this order for forming a transparent body. That is, the first transparent layer stack may be formed over the substrate with the conductive film being formed thereon.

Fig. 1 shows a structured (e.g., by patterning) transparent conductive film 22. It should be noted that embodiments herein also includes a non-structured (e.g., a non-patterned or substantially uniform film) transparent conductive film 22. In typical embodiments, due to the structure of the transparent layer stack, it is facilitated that the conductive film does not prejudice an optimal transmission of light through the body. In particular, a transparent layer stack according to embodiments herein facilitates that a conductive film, even a structured conductive film, does not affect the neutrality of the reflectance color, as further discussed below.

According to typical embodiments, deposition is performed by sputtering of one or more rotatable targets. More specifically, according to embodiments herein, at least one of the films referred to above is deposited by sputtering of a rotatable target, so that formation of a stable transparent body and with a high quality is facilitated. For example, according to embodiments herein, a film may be deposited having a higher uniformity, and with a low density of defects and contamination particles. Thereby, it is facilitated manufacturing of a high-quality transparent body that not only yields a proper transmission of light but also yields a stable performance over time. Furthermore, a manufacturing process including sputtering of one or more rotatable targets may further facilitate a higher manufacturing rate and the production of a lower number of contaminant particles as compared to other deposition methods.

According to certain embodiments, manufacturing of transparent body 10 further includes patterning of transparent conductive film 22. Thereby, formation of a transparent body for a touch panel implementing projected capacitive touch is facilitated.

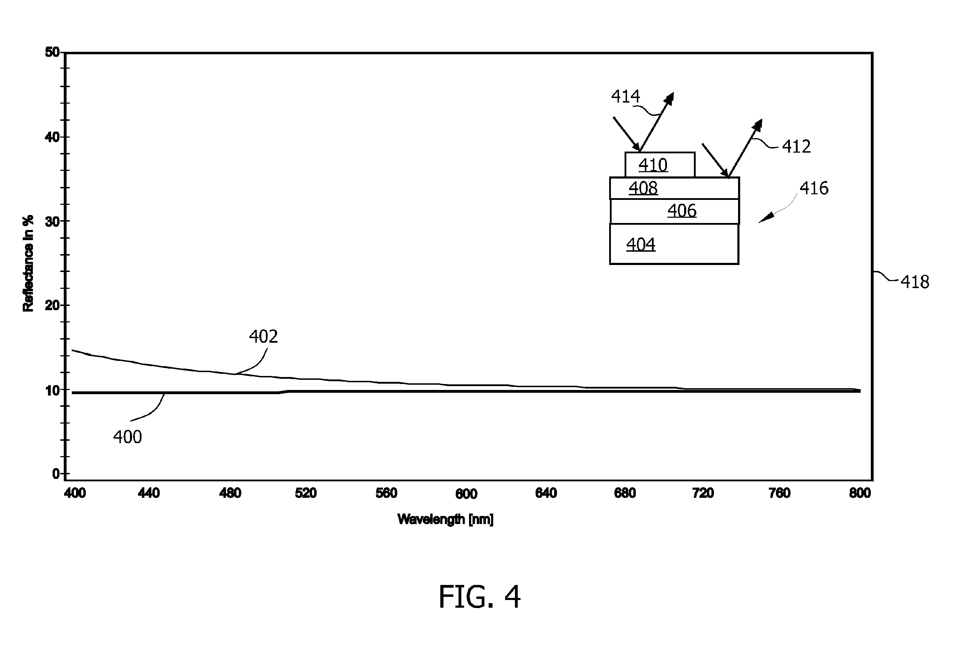

However, a patterned transparent conductive film 22 may further compromise the proper transmission of light through a transparent body for use in a touch panel. For example, at least some known transparent bodies for use in a touch panel are coated with two layers: a SiO₂ layer (forming the barrier) and a transparent ITO layer (forming the transparent conductor, i.e., an electroconductive coating). In some cases, the transparent ITO layer is partly removed by etching. Thereby, the optical properties, in particular the reflectance and transmittance, are modified in comparison to the transparent body with the unmodified deposited ITO layer. In particular, the reflectance/transmittance of the SiO₂/ITO layer is different from the reflectance/transmittance of the SiO2 layer. The resulting contrast/color difference (e.g., b* value as defined by the International Commission on Illumination (CIE) in 1976) may be visible and may be annoying to the user. This effect is exemplified in Fig. 4.

Fig. 4 shows a graph 418 illustrating the reflectance of a known transparent body 416 for use in a touch panel. Known transparent body 416 includes a PET substrate 404, a hardcoat 406 formed on PET substrate 404, a silicon oxide film 408 formed on hardcoat 406 and a patterned ITO film 410 formed on silicon oxide film 408. ITO film 410 may have a typical thickness of 15 nm and a 400 Ohm/square sheet resistance. Silicon oxide film 408 may have a typical thickness of 15 nm. In Fig. 4 it is further illustrated a reflected light 412 on silicon oxide film 408 and a reflected light 414 on patterned ITO film 410. Graph 418 illustrates a calculated reflectance of silicon oxide and patterned ITO on a hardcoated PET film. In particular, graph 418 includes the reflectance on silicon oxide 400 (corresponding to reflected light 412 on silicon oxide film 408) and the reflectance on silicon oxide and ITO 402 (corresponding to reflected light 414 on patterned ITO film 410).

From graph 418 it can be understood that there is an increase of reflectance for reflected light 414 on patterned ITO film 410 from 660 to 400 nm, which creates a slight "blue" reflection in comparison to the substantially neutral (i.e., constant) reflectance of reflected light 412 on silicon oxide film 408. This increase of reflection corresponds to a decrease of transmittance of patterned ITO film 410, so that the ITO patterned regions acquire a slightly yellow appearance. In contrast thereto, the reflectance/transmittance color of silicon oxide film 408 is substantially neutral. That is, the patterned conductive layer becomes "visible." However, it would be desirable to minimize this difference of reflectance/transmittance between patterned ITO film 410 and silicon oxide film 408. In other words, it would be desirable to design a transparent body in which the conductive layer is invisible without compromising stability and quality of the transparent body.

By the combination of dielectric films deposited according to embodiments of the present disclosure, in which at least one of the films is deposited by sputtering of a rotatable target, color neutrality of the transparent body, even when including a patterned conductive layer is facilitated. That is, using two additional layers in the barrier typically facilitate a significant reduction of the contrast between areas of the transparent body where the transparent conductive film is the top layer and areas where the dielectric film is the top layer. In other words, a transparent body manufactured according to embodiments herein facilitates rendering a contrast/color difference "invisible".

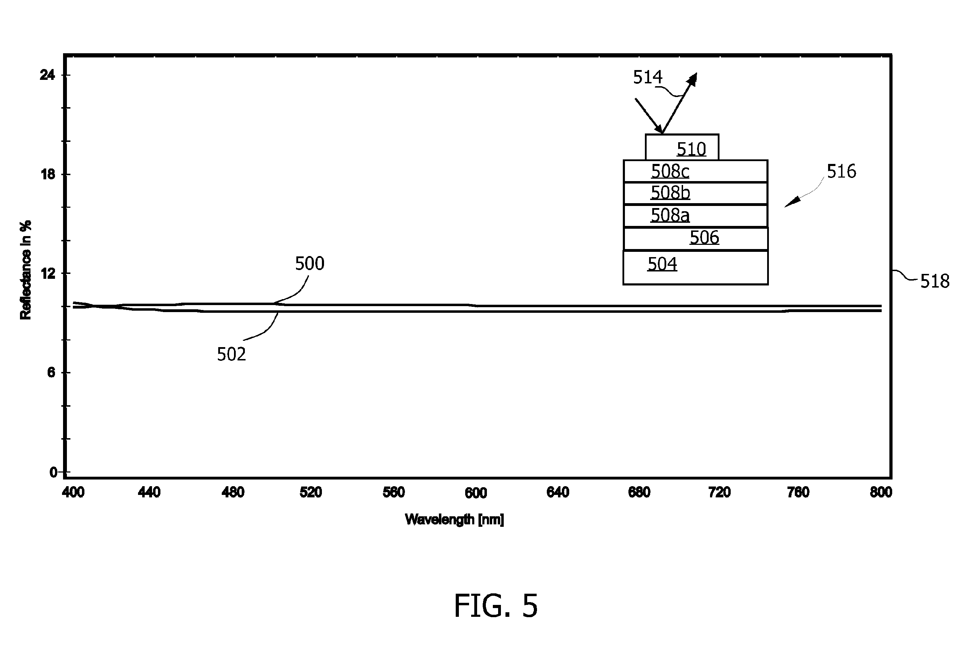

Fig. 5 shows a graph 518 illustrating the reflectance on silicon oxide 500 of a transparent body 516 according to embodiments of the present disclosure. Exemplary transparent body 516 includes a PET substrate 504, a hardcoat 506 formed on PET substrate 504, a silicon oxide (e.g., SiO₂) film 508a formed on hardcoat 506, a titanium oxide or niobium oxide (e.g., TiO₂ or NbO₅) film 508b formed on silicon oxide film 508a, a silicon oxide (e.g., SiO₂) film 508c formed on titanium oxide film 508b, and a patterned ITO film 510 formed on silicon oxide film 508c (silicon oxide film 508a having a thickness of 15 nm, titanium oxide film 508b having a thickness of 15 nm, silicon oxide film 508c having a thickness between 40 and 60 nm, and patterned ITO film 510 having a thickness of 15 nm).

Fig. 5 further illustrates a reflected light 514 on patterned ITO film 510. That is, graph 518 illustrates a calculated reflectance of a layer stack which may consist of a SiO₂ - TiO₂ - SiO₂ structure on a hardcoated PET in comparison with a layer stack which may consist of a SiO₂ - TiO₂ - SiO₂ - ITO structure, the ITO being patterned. In particular, graph 518 includes the reflectance on silicon oxide 500 (corresponding to reflected light on a transparent body, such as transparent body 516, without patterned ITO film 510) and the reflectance on silicon oxide and ITO 502 (corresponding to reflected light 514 on patterned ITO film 510).

From graph 518 it can be understood that the reflectance curves are almost identical, so that there is substantially no visual difference between the etched and non-etched parts of the conductive film. That is, the reflectance of the transparent body with an integral conductive layer, in this case ITO, is almost identical to that of a transparent body with a patterned conductive layer (e.g., partly removed by an etching process). The transmittance (not shown) evidences a corresponding behavior. In contrast to the reflectance of at least some known transparent bodies for touch panels, such as the SiO₂ - ITO structure in Fig. 4, the reflection/transmission color of transparent body 516 is substantially neutral (i.e. with a b* value near 0). It should be noted that, surprisingly, graph 518 evidences a slightly increased transmittance of a transparent body with two additional films in respect to at least some known transparent bodies for use in a touch panel.

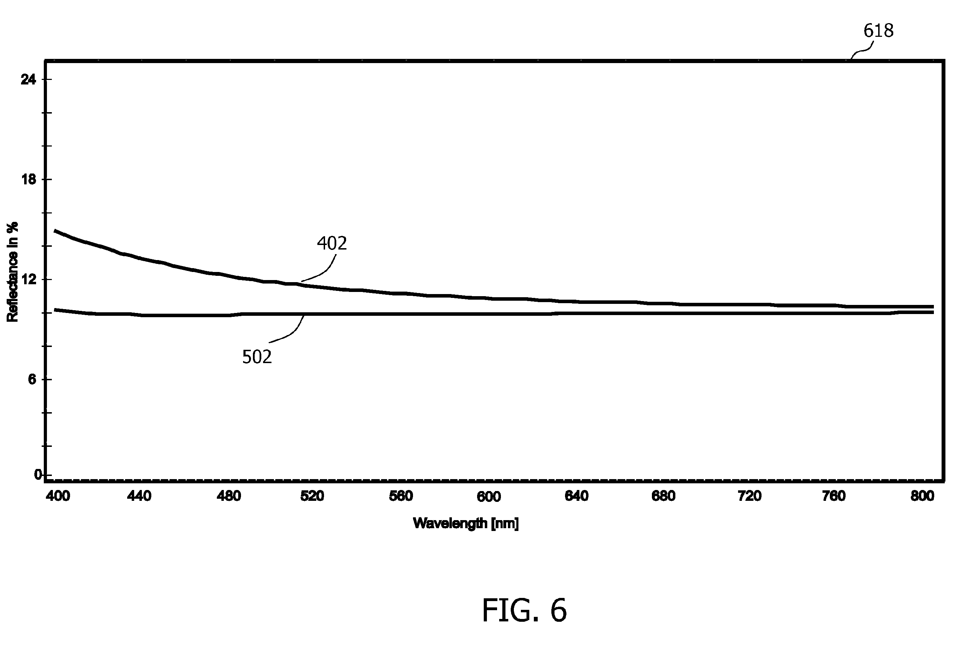

Fig. 6 shows a graph 618 directly comparing reflectance on silicon oxide and ITO 402 from Fig. 4 and reflectance on silicon oxide and ITO 502 from Fig. 5. From this figure, it can be further understood that, compared to a "two-layer" system, a "four-layer" system according to embodiments herein facilitates that the reflection on the transparent body is not increased in the blue region of the visible spectrum. That is, a transparent body manufactured according to embodiments herein typically facilitates improved color neutrality.

According to certain embodiments, the first transparent layer stack and the transparent conductive film are deposited in a manner such that the b* value for the manufactured transparent body is below 1.5 or, in particular 1, or more specifically, 0.7, or, even more specifically, 0.2. In particular, according to embodiments herein, the b* value for the structure formed solely by the first transparent layer stack and the transparent conductive film and placed above a substantially transparent substrate may adopt these values.

According to certain embodiments, the thickness and/or the refractive indexes of the films included in the first transparent layer stack and the transparent conductive film may be chosen in a manner such that the b* value for the manufactured transparent body is below 1.5 or, in particular 1, or more specifically, 0.7, or, even more specifically, 0.2. Thickness values for the films in an exemplary transparent body are discussed below. It should be noted that, in particular, for a different thickness or composition of the transparent conductive film, it may be necessary to correspondingly adapt the thickness of the other films in the transparent body in order to achieve a particular b* value.

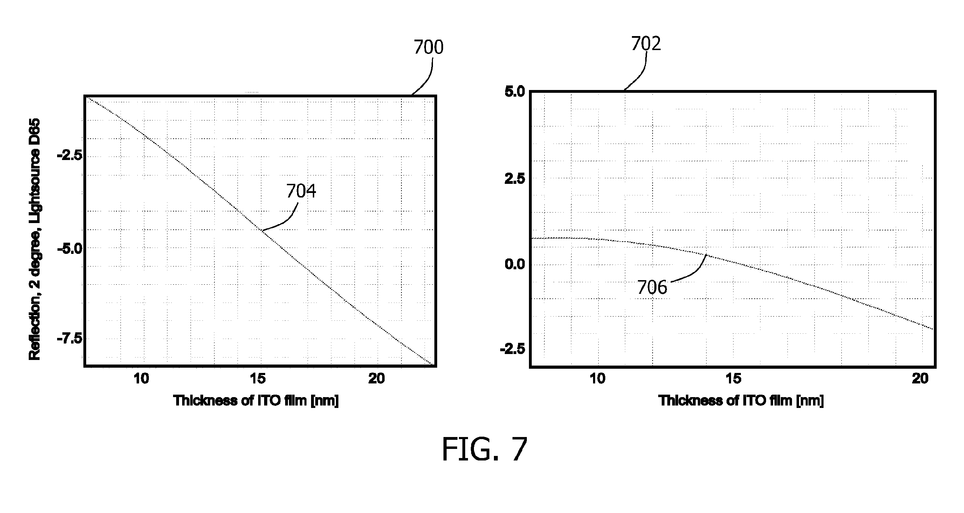

Fig. 7 shows two graphs 700, 702 which illustrate b* values 704 of a transparent body with a similar structure to the know transparent body of Fig. 4 (graph 700) and b* values 706 of a transparent body with a similar structure to the exemplary transparent body of Fig. 5 (graph 702) for different thicknesses of patterned ITO film 410 and patterned ITO film 510. From Fig. 7 it can be appreciated that the color of the known "2-layer" transparent body 416 of Fig. 4 has a calculated b* value (reflectance) of approximately -4.5. In contrast thereto, exemplary transparent body 516, deposited according to embodiments herein, has a b* value close to zero.

Additionally, a comparison between graph 700 and graph 702 shows that a transparent body deposited according to embodiments herein facilitates a significantly reduced sensitivity of the b* value to a variation in the thickness of the conductive film (in the example, patterned ITO film 510) compared to the "2-layer" structure of at least some known transparent bodies. Therefore, a transparent body deposited according to embodiments herein facilitates a better control of the optical properties of the body, such as the b* value, in particular, in view of possible variations of manufacturing parameters, such as the thickness of the conductive layer.

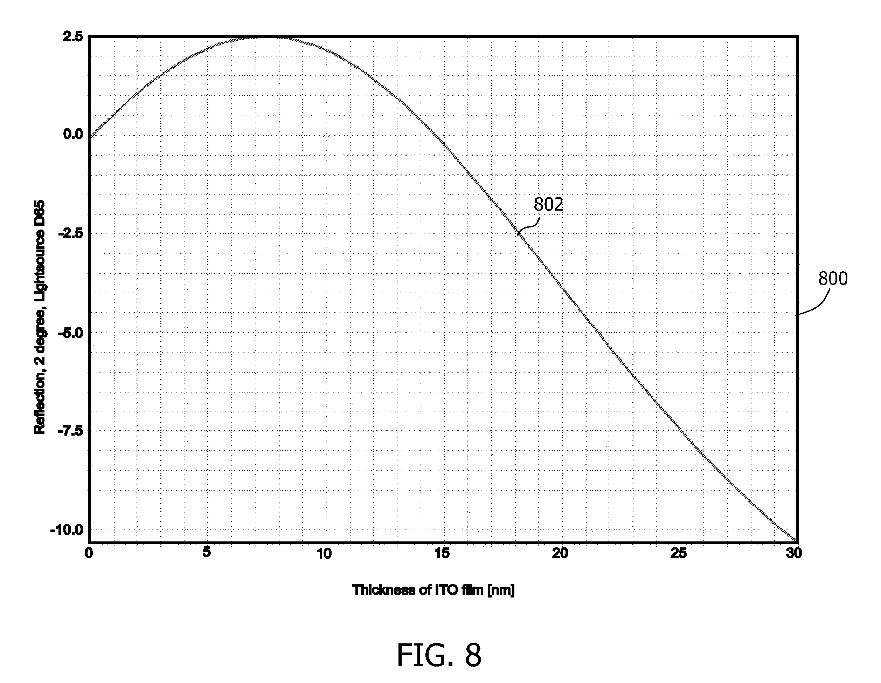

Fig. 8 shows a graph 800 illustrating b* values 802 of a transparent body with the structure of the exemplary transparent body of Fig. 5. From graph 800 it can be further understood that exemplary transparent body 516, i.e., a transparent body deposited according to embodiments herein with an ITO layer thickness of 15 nm, has a substantially neutral reflectance with and without conductive film thereon. Therefore, a transparent body deposited to at least some of the embodiments herein facilitates the manufacturing of a transparent body for use in a touch panel with a substantially neutral reflectance color without compromising stability of the manufactured films.

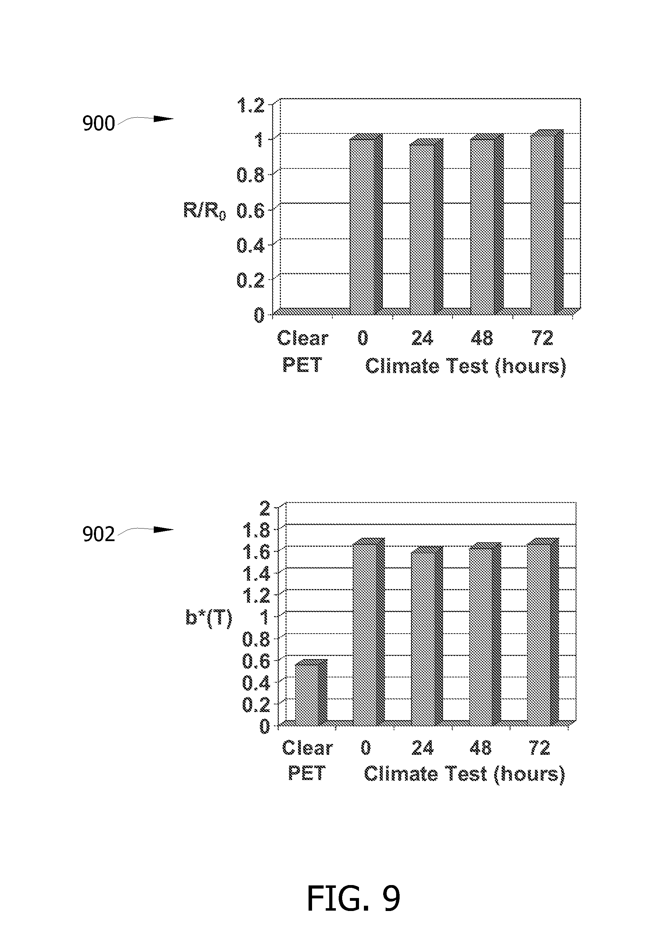

Embodiments of the present disclosure provide a manufacturing process, which not only yields a proper transmission of light but also yields a stable performance over time as evidenced by Fig. 9. In particular, Fig. 9 shows two graphs 900, 902 evidencing stable performance of a transparent body manufactured according to embodiments herein.

Graph 900 shows variation of the ratio (R/R0) between resistance of an ITO film forming part of a transparent body according to embodiments herein before a climate test (R) and resistance of the ITO film after the climate test (R0). From graph 900 it can be understood that a transparent body manufactured according to embodiments herein facilitates a stable resistance of the conductive film over time, even under harsh climate conditions. Graph 902 shows variation of b* values with time during a climate test. From graph 902 it can be understood that a transparent body manufactured according to embodiments herein facilitates a stable b* value over time, even under harsh climate conditions.

Therefore, a transparent body manufactured according to embodiments herein facilitates proper and stable optical performance of a touch panel, even under harsh conditions.

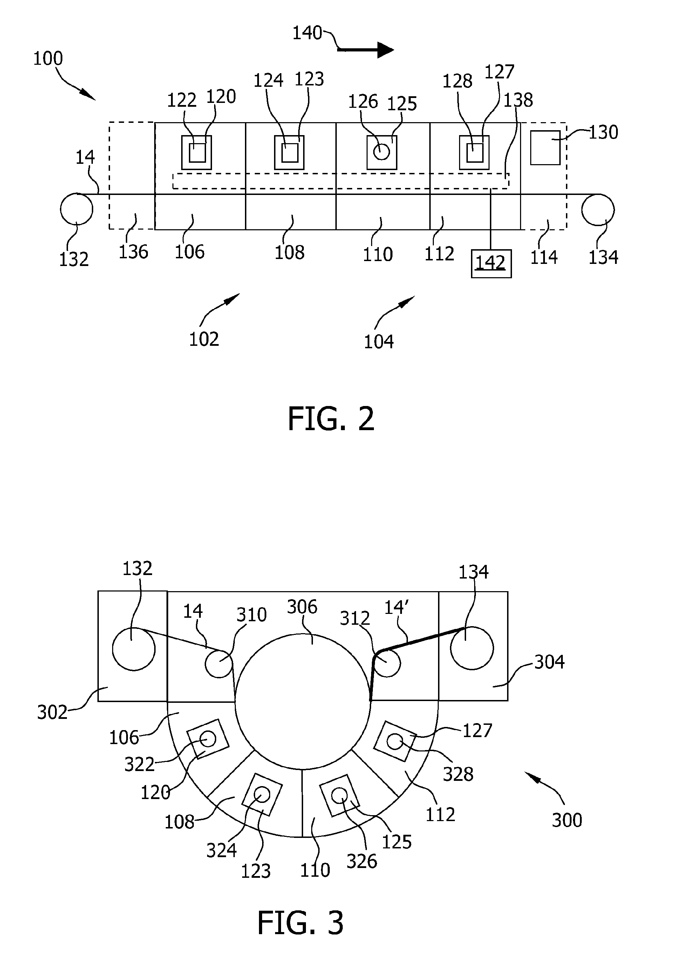

Fig. 2 schematically illustrates an example of a deposition apparatus 100 for manufacturing a transparent body for use in a touch panel according to embodiments herein. The exemplarily apparatus includes a first deposition assembly 102 configured to deposit a first transparent layer stack 12 over a substrate 14, first transparent layer stack 12 including a first dielectric film 16, a second dielectric film 18 and a third dielectric film 20. According to typical embodiments, each film of layer stack 12 is deposited in an individual deposition chamber. In particular, exemplary deposition apparatus 100 includes a first dielectric film deposition chamber 106 configured to deposit first dielectric film 16, a second dielectric film deposition chamber 108 configured to deposit second dielectric film 18, and a third dielectric film deposition chamber 110 configured to deposit third dielectric film 20. The exemplary deposition apparatus 100 also includes a second deposition assembly 104 configured to deposit a transparent conductive film 22. In particular, exemplary deposition apparatus 100 includes a conductive film deposition chamber 112 configured to deposit transparent conductive film 22.

According to embodiments herein, first deposition assembly 102 and second deposition assembly 104 are arranged such that first transparent layer stack 12 and transparent conductive film 22 are disposed over substrate 14 in this order. In the exemplary embodiment, substrate 14 is conveyed through the chamber by a conveyor system (not shown) along a deposition path in a deposition direction 140. In the exemplary embodiment, first deposition assembly 102 is arranged upstream relative to second deposition assembly 104, so that transparent conductive film 22 is deposited over first transparent stack 12.

According to typical embodiments, deposition apparatus 100 is configured to deposit the first and the third dielectric films having a low refractive index and the second dielectric film having a high refractive index. For example, first dielectric film deposition chamber 106 and third dielectric film deposition chamber 110 may be configured to deposit silicon oxide, and second dielectric film deposition chamber 108 may be configured for depositing a metal oxide or a metal nitride, such as, but not limited to titanium oxide or niobium oxide.

According to typical embodiments, first deposition assembly 102 is configured to deposit first dielectric film 16, second dielectric film 18, and third dielectric film 20 over the substrate in this order. In the exemplary embodiment, first dielectric film deposition chamber 106, second dielectric film deposition chamber 108, and third dielectric film deposition chamber 110 are disposed in this order along the deposition path, so that, first dielectric film 16, second dielectric film 18, and third dielectric film 20 are deposited over substrate 14 in this order and, in particular, one atop another.

The deposition chambers may include any suitable structure, configuration, arrangement, and/or components that enable deposition apparatus 100 to deposit a transparent body according to embodiments of the present disclosure. For example, but not limited to, the deposition chambers may include suitable deposition systems including coating sources, power sources, individual pressure controls, deposition control systems, and temperature control. According to typical embodiments, the chambers are provided with individual gas supplies. The chambers are typically separated from each other for providing a good gas separation. For example, the deposition chambers may be separated from each other in a manner such that the ratio of gases expanding from other chambers into a particular chamber to gas directly supplied to the particular chamber is of at least 1 to 100. A deposition apparatus 100 according to embodiments herein is not limited in the number of deposition chambers. For example, but not limited to, deposition apparatus 100 may include 3, 6, or 12 deposition chambers.

According to typical embodiments, any of the film deposition chambers of deposition apparatus 100 may be configured for performing deposition by sputtering, such as magnetron sputtering. In particular, first deposition assembly 102 may be configured for depositing first transparent stack 12 by magnetron sputtering and/or second deposition assembly 104 may be configured for performing deposition by magnetron sputtering.

As used herein, "magnetron sputtering" refers to sputtering performed using a magnet assembly, that is, a unit capable of a generating a magnetic field. Typically, such a magnet assembly consists of a permanent magnet. This permanent magnet is typically arranged within a rotatable target or coupled to a planar target in a manner such that the free electrons are trapped within the generated magnetic field generated below the rotatable target surface. Such a magnet assembly may also be arranged coupled to a planar cathode.

Magnetron sputtering may also be realized by a double magnetron cathode, such as, but not limited to, a TwinMag^{™} cathode assembly. According to typical embodiments, the cathodes in a deposition chamber may be interchangeable. Thereby, a modular design of the apparatus is provided which facilitates optimizing the apparatus for particular manufacture requirements. According to typical embodiments, the number of cathodes in a chamber for sputtering deposition is chosen for optimizing an optimal productivity of the deposition apparatus.

According to certain embodiments, one or some of the chambers may be configured for performing sputtering without a magnetron assembly. In particular, one or some of the chambers may be configured for performing deposition by other methods, such as, but not limited to, chemical vapor deposition or pulsed laser deposition.

According to typical embodiments, at least one of first deposition assembly 102 or second deposition assembly 104 includes a sputtering system operatively coupled to a rotatable target. According to these embodiments, the sputtering system is configured to deposit at least one of first dielectric film 16, second dielectric film 18, third dielectric film 20, or transparent conductive film transparent conductive film 22 by sputtering of the rotatable target. According to a particular embodiment, second deposition assembly 104 includes a sputtering system 127 operatively coupled to a rotatable target for depositing film transparent conductive film 22 by sputtering of the rotatable target.

According to certain embodiments, at least first deposition assembly 102 includes a sputtering system operatively coupled to a rotatable target for deposition of at least one of first dielectric film 16, second dielectric film 18, or third dielectric film 20 by sputtering of a rotatable target. According to certain embodiments, at least first deposition assembly 102 includes a sputtering system operatively coupled to a rotatable target for deposition of at least first dielectric film 16 and second dielectric film 18 by sputtering of a rotatable target. According to certain embodiments, first deposition assembly 102 and second deposition assembly 104 include a sputtering system operatively coupled to a rotatable target for deposition of first dielectric film 16, second dielectric film 18, third dielectric film 20, and transparent conductive film transparent conductive film 22 by sputtering of a rotatable target.

According to certain embodiments, first deposition assembly 102 and second deposition assembly 104 include a plurality of targets, wherein one, some or all of the targets may be rotatable, configured in a manner such that first dielectric film 16, second dielectric film 18, third dielectric film 20, and transparent conductive film 22 can be deposited by sputtering of the targets. In the exemplary embodiment, each of the deposition chambers of deposition apparatus 100 includes a sputtering system. In particular, first dielectric film deposition chamber 106 is provided with sputtering system 120, second dielectric film deposition chamber 108 is provided with sputtering system 123, third dielectric film deposition chamber 110 is provided with sputtering system 125, and conductive film deposition chamber 112 is provided with sputtering system 127.

In particular, according to certain embodiments, each of the deposition systems in deposition apparatus 100 is operatively coupled to a respective rotatable target for deposition of the respective film. In the exemplary embodiment, sputtering system 120 is operatively coupled to a target 122 (which, e.g., may be a rotatable target or adapted for a planar cathode), sputtering system 123 is operatively coupled to a target 124 (which, e.g., may be a rotatable target or adapted for a planar cathode), sputtering system 125 is operatively coupled to a rotatable target 126 (which, alternatively may be adapted, e.g., for a planar cathode), and sputtering system 127 is operatively coupled to a target 128 (which, e.g., may be a rotatable target or adapted for a planar cathode). According to typical embodiments, a rotatable target is formed by one or more cylindrical targets suitably arranged for depositing a film over substrate 14.

According to typical embodiments, sputtering may be performed by direct sputtering. By direct sputtering is meant a process including sputtering a target containing the material to be deposited in reacted form. For example, sputtering may include sputtering a target including silicon oxide for deposition of silicon oxide over a substrate. Direct sputtering facilitates a less complex construction of the deposition systems, since a reactive component gas is then no longer required. Alternatively, sputtering may be performed by other sputtering methods such as, but not limited to, reactive sputtering.

According to certain embodiments, first deposition assembly 102 is configured for depositing third dielectric film 20 by direct sputtering of dielectric material. According to a particular embodiment, first deposition assembly 102 includes a rotatable target, e.g., rotatable target 126, which target includes niobium oxide, and first deposition assembly 102 is configured for depositing third dielectric film 20 by direct sputtering of the rotatable target including niobium oxide (such as Nb₂O₅). Such a deposition of third dielectric film 20 facilitates yielding particularly good results in the manufacture of a transparent body according to embodiments herein. For example, third dielectric film deposition chamber 110 may provide an inert gas atmosphere for deposition of the sputtered material, in this case niobium oxide.

According to typical embodiments, deposition apparatus 100 includes a measurement system 138 configured for measuring during deposition optical properties of at least one of the films forming part of first transparent layer stack 12 or transparent conductive film 22. For example, deposition apparatus 100 may implement inline optical spectrophotometric measurement during the deposition of the films. Thereby, an online monitoring of the deposition process is enabled.

Deposition apparatus 100 may include a control system 142 operatively coupled to measurement system 138 for closed loop control of the deposition of at least one of the films forming part of at least one of first transparent layer stack 12 or the transparent conductive film. Thereby, the deposition of each layer may be individually controlled, so that film thickness, composition, or optical properties may be controlled with high precision. An individual control of film properties facilitates the formation of a stable transparent body having an optimized light transmittance.

According to typical embodiments, deposition apparatus 100 includes a temperature control system (not shown) for controlling the temperature at different areas of the deposition path, or other modules of deposition apparatus 100, such as a pre-treatment module, or a post-processing module. Furthermore, according to certain embodiments, such a temperature control system may individually control the temperature of substrate 14 at a deposition chamber.

The exemplary embodiment of Fig. 2 may also include a pre-treatment chamber 136 for performing a pre-treatment of substrate 14 prior to deposition. For example, pre-treatment chamber 136 may be configured to perform DC and/or MF pre-treatment of substrate 14 with a power between 1 or 3 kW (depending on substrate speed). Moreover, pre-treatment chamber 136 may be configured for performing pre-treatment of substrate 14 at an argon and/or oxygen atmosphere, so that, for example, an oxygen rich pre-treatment may be performed.

According to certain embodiments, deposition apparatus 100 may include a patterning chamber 114 for performing patterning of transparent body 10. In particular, patterning chamber 114 may include a sputtering system 130 for patterning of transparent conductive film 22, for example by etching thereof. Thereby, transparent body 10 may be fabricated for being suitable for a touch panel implementing projected capacitive touch. In typical embodiments, patterning chamber 114 may be configured for forming an X-Y grid by patterning (e.g., etching) of transparent conductive film 22, so that a grid pattern of electrodes if formed over substrate 14. In this cases, a transparent body 10 according to embodiments herein is particularly advantageous since compensation of the variation of reflectance over the display area due to a patterned conductive layer is facilitated without compromising stability and quality of the transparent body, as discussed above.

According to typical embodiments, substrate 14 consists of a flexible substrate, such as a hardcoated PET foil, and deposition apparatus 100 may include an unwind roller 132 and a rewind roller 134 for unwinding of substrate 14 prior to deposition and winding of substrate 14 after formation of a transparent body according to embodiments herein. Deposition apparatus 100 may include a roller system (not shown) for translation of substrate 14 through the different processing chambers. In particular, a deposition apparatus according to embodiments herein may be constituted as a sputter roll coater for roll-to-roll deposition on a plastic film.

Within the following description of the drawings, the same reference numbers refer to similar components. Generally, only the differences with respect to the individual embodiments are described. Fig. 3 shows an exemplary deposition apparatus 300 for manufacturing of a transparent body for use in a touch panel in accordance with embodiments herein. Exemplary deposition apparatus 300 is constituted as a roll-to-roll system including an unwinding module 302, a winding module 304, and a process module 308 disposed therebetween. Process module 308 includes a first dielectric film deposition chamber 106, a second dielectric film deposition chamber 108, a third dielectric film deposition chamber 110, and a conductive film deposition chamber 112 similar to those discussed with regard to Fig. 2, but radially disposed about a processing drum 306.

Process module 308 may further include auxiliary rollers 310, 312 for appropriately feeding a substrate 14 to processing drum 306, and facilitating feeding of a processed substrate 14' from process module 308 to winding module 304. Deposition apparatus 300 may be a SmartWeb^{™}, manufactured by Applied Materials, adapted for manufacturing a transparent body according to embodiments of the present disclosure. Examples of a roll-to-roll deposition apparatus which could be adapted according to embodiments herein are described in European patent application Appl. No. EP20040003574, entitled "Strip coating installation with a vacuum chamber and a coating cylinder" filed February 18, 2004 and published under publication number EP 1 561 837 A1, which is incorporated herein by reference to the extent the application is not inconsistent with this disclosure.

According to certain embodiments, deposition apparatus 300 further includes additional processing modules for performing additional processing on substrate 14 or processed substrate 14'. Moreover, a plurality of deposition apparatuses 300 may be disposed in series for scaling productivity of a transparent body according to embodiments herein. Examples of a scalable deposition system which could be adapted according to embodiments herein are described in European patent application Appl. No. EP20040008699, entitled "Guide arrangement with at least one guide roll for guiding webs in web treating apparatuses" filed April 13, 2004 and published under publication number EP 1 589 130 A1, which is incorporated herein by reference to the extent the application is not inconsistent with this disclosure.

In the exemplary embodiment of Fig. 3, sputtering system 120 is operatively coupled to a rotatable target 322 (which, alternatively may be adapted for a planar cathode), sputtering system 123 is operatively coupled to a rotatable target 324 (which, alternatively may be adapted for a planar cathode), sputtering system 125 is operatively coupled to a rotatable target 326 (which, alternatively may be adapted for a planar cathode), and sputtering system 127 is operatively coupled to a rotatable target 328 (which, alternatively may be adapted for a planar cathode).

Fig. 10 is a flow chart illustrating an exemplary process 200 for manufacturing a transparent body, such as exemplary transparent body 10. Such a process may be performed, for example, in any of the exemplary apparatuses of Fig. 2 or Fig. 3.

Exemplary process 200 includes depositing 202 a first transparent layer stack over a substrate, the first transparent layer stack including a first dielectric film, a second dielectric film, and a third dielectric film, the first and the third dielectric films having a low refractive index and the second dielectric film having a high refractive index. According to certain embodiments, deposition 202 is performed in a manner such that the first dielectric film, the second dielectric film, and the third dielectric film are disposed over the substrate in this order and, eventually, one atop another.

According to certain embodiments, the first dielectric film and/or the third dielectric film include or consist of silicon oxide (in particular, SiO₂). Alternatively, the first dielectric film and/or the third dielectric film may include or consist of magnesium fluoride (in particular, MgF₂). According to some embodiments, the second dielectric film includes or consists of a metallic oxide film. Alternatively, the second dielectric film may include or consist of a metallic nitride film. In particular, the second dielectric film may include or consist of titanium oxide (in particular, TiO₂), niobium oxide (in particular, Nb₂O₅), titanium nitride (in particular, Ti₃N₄), niobium nitride (in particular, Nb₃N₅), or a metal oxinitride, such as titanium oxinitride (in particular, TiNxOy) or niobium oxinitride (in particular, NbNxOy). As set forth above, according to typical embodiments, the first and the third dielectric films include a dielectric material having a refractive index lower than 1.5 and/or the second dielectric films includes a dielectric material having a refractive index of at least 1.8.

Exemplary process 200 further includes depositing 204 a transparent conductive film in a manner such that the first transparent layer stack and the transparent conductive film are disposed over the substrate in this order.

In exemplary process 200, at least one of the first dielectric film, the second dielectric film, the third dielectric film, or the transparent conductive film is deposited by sputtering of a rotatable target. In particular embodiments, the second dielectric film and the third dielectric film are deposited by sputtering of a rotatable target. In certain embodiments, at least one of the first dielectric film, the second dielectric film, and the third dielectric film is deposited by sputtering of a rotatable target. In certain embodiments, the first dielectric film, the second dielectric film, the third dielectric film, and the transparent conductive film are deposited by sputtering of a rotatable target. According to certain embodiments, at least the transparent conductive film. Thereby, particularly good results in the manufacturing of the transparent body for a particular application thereof may be achieved.

According to particular embodiments, the first transparent layer stack and the transparent conductive film are deposited by magnetron sputtering. According to certain embodiments, the third dielectric film is deposited by direct sputtering of dielectric material. In particular, the third dielectric film may be deposited by direct sputtering of niobium oxide (in particular, Nb₂O₅). Thereby, particularly good results in the manufacturing of the transparent body may be achieved.

Exemplary process 200 may further include patterning 206 the transparent conductive film. For example, a portion of the deposited transparent conductive film may be etched. According to certain embodiments, the transparent conductive film is patterned in a manner such that the transparent body is configured for being implemented into a projected capacitive touch panel. In particular embodiments, the transparent conductive film is patterned in a manner such that the transparent body is configured for being implemented into a mutual capacitive sensor of a touch panel.

According to certain embodiments, exemplary process 200 includes a heating treatment of the substrate for degassing of the substrate prior to deposition. For example, the substrate may be heated at a temperature between 60 and 200 °C depending on the substrate speed. According to certain embodiments, exemplary process 200 may include performing a DC and/or medium frequency (MF) pre-treatment of the substrate with a power between 1 or 3 kW (depending on substrate speed). Moreover, exemplary process 200 may include performing a pre-treatment of the substrate at an argon and/or oxygen atmosphere such as, for example, an oxygen rich pre-treatment. According to embodiments herein, medium frequency is a frequency in the range of 5 kHz to 100 kHz, for example, 30 kHz to 50 kHz.

The sputter coating sources in the exemplary deposition apparatuses or in an apparatus according to embodiments herein may be a DC-cathode with planar targets (such as, but not limited to, ceramic ITO and ceramic Nb₂O₅), a MF-cathode with planar targets (such as, but not limited to, a doped silicon target for depositing SiO₂), a DC-cathode (such as, but not limited to, a ROT cathode) with cylindrical targets (such as, but not limited to, an ITO or a Nb₂O₅ target), or a MF-cathode (such as, but not limited to, a ROT cathode) with a cylindrical target (such as a doped silicon target, in particular sprayed for depositing SiO₂,). According to typical embodiments, the films of the transparent body are deposited in one continuous run. In particular, the films may be deposited with different partial gas pressures (e.g., O₂ partial pressure) in the individual deposition chambers.

According to typical embodiments, the first dielectric film is sputtered using a planar cathode with doped silicon. Alternatively, a cylindrical cathode with doped silicon may be used. Further, the first dielectric film may be sputtered using a MF power source. Further, the first dielectric film may be sputtered by reactive sputtering, for example in the presence of an inert gas, such as argon, and oxygen in the deposition chamber. Further, a typical process pressure for the first dielectric film may be between 2x10⁻³ and 8x10⁻³ mbar. Further, typical deposition rates may be between 10 and 20 nm/min or, in particular when a cylindrical cathode is used, between 20 and 30 nm/min.

According to typical embodiments, a cylindrical cathode with a ceramic Nb₂O₅ may be used. Alternatively, the second dielectric film may be sputtered using a planar cathode with ceramic Nb₂O₅. Further, the first layer may be sputtered using a continuous (DC) power source. Further, the second dielectric film may be sputtered by direct sputtering, for example in the presence of an inert gas, such as argon, in the deposition chamber. Further, typical process pressure for the second dielectric film may be between 2x10⁻³ and 8x10⁻³ mbar. Further, typical deposition rates may be between 10 and 20 nm/min (when a planar cathode is used) or between 20 and 30 nm/min (when a cylindrical cathode is used.)

According to typical embodiments, the third dielectric film is sputtered using a cylindrical cathode with doped silicon. Alternatively, a planar cathode with doped silicon may be used. Further, the third dielectric film may be sputtered using a medium frequency (MF) power source. Further, the third dielectric film may be sputtered by reactive sputtering, for example in the presence of an inert gas, such as argon, and oxygen in the deposition chamber. Further, a typical process pressure for the third dielectric film may be between 2x10⁻³ and 8x10⁻³ mbar. Further, typical deposition rates may be between 20 and 40 nm/min (when a planar cathode is used) or between 30 and 60 nm/min (when a cylindrical cathode is used.)

According to typical embodiments, the transparent conductive film is sputtered using a cylindrical cathode with ITO, for example typ. (In₂O₃/SnO₂) with 90% indium oxide and 10% tin dioxide. Alternatively, a planar cathode with ITO may be used. Further, the transparent conductive film may be sputtered using a continuous (DC) power source. Further, the transparent conductive film may be sputtered by direct or reactive sputtering, for example in the presence of an inert gas, such as argon, and oxygen or an inert gas, such as argon, as only gas supplied to the particular deposition chamber. Further, typical process pressure for the transparent conductive film may be between 2x10⁻³ and 8x10⁻³ mbar. Further, typical deposition rates may be between 10 and 20 nm/min (when a planar cathode is used) or between 20 and 30 nm/min (when a cylindrical cathode is used.)

As detailed above, the number of cathodes for depositing each of the films is typically optimized for an optimal productivity. In particular, the number of cathodes may be optimized for a sputter web machine with 3, 6, or 12 compartments.

Embodiments of the present disclosure also include a transparent body produced by a process according to embodiments herein. The transparent body may include a first transparent layer stack over a substrate. The first transparent layer stack may include a first dielectric film, a second dielectric film, a third dielectric film and a transparent conductive film. The first transparent layer stack and the transparent conductive film may be disposed over the substrate in this order and the first and the third dielectric films may have a low refractive index and the second dielectric film may have a high refractive index. In particular, the first and the third dielectric films may have a lower refractive index than the second dielectric film.

Embodiments of the present disclosure also include a touch panel including a transparent body according to embodiments herein. Embodiments of the present disclosure also include a touch panel including a transparent body according to embodiments herein, wherein the transparent body is configured for providing multi-touch detection capabilities. For example, the transparent conductive film may be configured as an X-Y grid. In particular, the transparent body may be configured for implementing projected capacitive touch (PCT) sensing. Furthermore, the transparent body may be configured for being used as a mutual capacitive sensor.

It is noted that for calculating reflectance in graph 418 in Fig. 4 and graph 518 in Fig. 5, it was assumed a PET substrate (refractive index 1.60) with backside reflection and without an outer substrate and without beam reverse, an air medium (refractive index 1.00), and light incidence angle of 0 degrees. Furthermore, the b* values in Figs. 7 and 8, as indicated in the figures, refer to reflection with 2 degrees and light source D65.

The written description uses examples to disclose the invention, including the best mode, and to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. For example, first deposition assembly and/or the second deposition assembly may be configured for depositing the first transparent stack and/or the transparent conductive film by magnetron sputtering. It should be noted that a transparent body manufactured according to embodiments herein may be applicable to a glass substrate. Furthermore, according to certain embodiments, at least the transparent conductive film of the transparent body, such as, but not limited to, a ITO film, is deposited by sputtering of a rotatable target.

The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A process for manufacturing a transparent body (10) for use in a touch panel, the process comprising:
depositing a first transparent layer stack (12) over a substrate (14), said first transparent layer stack (12) including a first dielectric film (16), a second dielectric film (18), and a third dielectric film (20), the first and the third dielectric films having a low refractive index and the second dielectric film having a high refractive index; and
depositing a transparent conductive film (22) in a manner such that the first transparent layer stack (12) and the transparent conductive film (22) are disposed over the substrate (14) in this order;
wherein at least one of the first dielectric film (16), the second dielectric film (18), the third dielectric film (20), or the transparent conductive film (22) is deposited by sputtering of a rotatable target (122, 124, 126, 128, 322, 324, 326, 328).

2. The process according to claim 1, wherein the first dielectric film (16), the second dielectric film (18), and the third dielectric film (20) are disposed over the substrate in this order.

3. The process according to any of the preceding claims, further comprising patterning the transparent conductive film (22).

4. The process according to any of the preceding claims, wherein the first and the third dielectric films have a refractive index lower than 1.5 and the second dielectric films has a refractive index of at least 1.8.

5. The process according to any of the preceding claims, wherein at least one of the first dielectric film or the third dielectric film include silicon oxide or magnesium fluoride.

6. The process according to any of the preceding claims, wherein the third dielectric film includes a metal oxide, a metal nitride, or a metal oxinitride.

7. The process according to any of the preceding claims, wherein the third dielectric film is deposited by direct sputtering of dielectric material.

8. A deposition apparatus (100) for manufacturing a transparent body (10) for use in a touch panel, said apparatus comprising:
a first deposition assembly (102) configured to deposit a first transparent layer stack (12) over a substrate (14), said first transparent layer stack (12) including a first dielectric film (16), a second dielectric film (18) and a third dielectric film (20), the first and the third dielectric films having a low refractive index and the second dielectric film having a high refractive index; and
a second deposition assembly (104) configured to deposit a transparent conductive film (22),
wherein said first deposition assembly (102) and said second deposition assembly (104) are arranged such that the first transparent layer stack (12) and the transparent conductive film (22) are disposed over the substrate (14) in this order, and
at least one of the first deposition assembly (102) or the second deposition assembly comprises a sputtering system (120, 123, 125, 125) operatively coupled to a rotatable target (122, 124, 126, 128, 322, 324, 326, 328), said sputtering system being configured to deposit at least one of the first dielectric film (16), the second dielectric film (18), the third dielectric film (20), or the transparent conductive film (22) by sputtering of the rotatable target.

9. The apparatus according to claim 8, wherein the first deposition assembly (102) is configured to deposit the first dielectric film (16), the second dielectric film (18), and the third dielectric film (20) over the substrate in this order.

10. The apparatus according to any of claims 8 to 9, wherein the first deposition assembly (102) and the second deposition assembly (104) are configured for depositing the first transparent stack (12) and the transparent conductive film (22) by magnetron sputtering.

11. The apparatus according to any of claims 8 to 10, further comprising a measurement system (138) configured for measuring during deposition optical properties of at least one of the films forming part of at least one of the first layer stack or the transparent conductive film.

12. The apparatus according to any of claims 8 to 11, wherein the first deposition assembly (102) is configured for depositing the third dielectric film (20) by direct sputtering of dielectric material.

13. The apparatus according to any of claims 8 to 12, wherein the first deposition assembly (102) and the second deposition assembly (104) include a plurality of rotatable targets (122, 124, 126, 128, 122, 324, 326, 328) configured in a manner such that the first dielectric film (16), the second dielectric film (20), the third dielectric film (18), and the transparent conductive film (22) can be deposited by sputtering of the rotatable targets.

14. A transparent body (10) produced by the process according to any of claims 1 to 7, comprising:
a first transparent layer stack (12) over a substrate (14), said first transparent layer stack (12) including a first dielectric film (16), a second dielectric film (18), a third dielectric film (20) and a transparent conductive film (22),
wherein the first transparent layer stack (12) and the transparent conductive film (22) are disposed over the substrate (14) in this order and the first and the third dielectric films having a low refractive index and the second dielectric film having a high refractive index.

15. A touch panel comprising a transparent body (10) according to claim 14.

## Amended claims

### Amended claims in accordance with Rule 137(2) EPC.

**1.** A process for manufacturing a transparent body (10) for use in a touch panel, the process comprising:
depositing a first transparent layer stack (12) over a substrate (14), said first transparent layer stack (12) including a first dielectric film (16), a second dielectric film (18), and a third dielectric film (20), the first and the third dielectric films having a refractive index lower than 1.5 and the second dielectric film having a refractive index of at least 1.8; and
depositing a transparent conductive film (22) in a manner such that the first transparent layer stack (12) and the transparent conductive film (22) are disposed over the substrate (14) in this order;
**characterised in that** at least one of the first dielectric film (16), the second dielectric film (18), the third dielectric film (20), or the transparent conductive film (22) is deposited by sputtering of a rotatable target (122, 124, 126, 128, 322, 324, 326, 328).

**2.** The process according to claim 1, wherein the first dielectric film (16), the second dielectric film (18), and the third dielectric film (20) are disposed over the substrate in this order.

**3.** The process according to any of the preceding claims, further comprising patterning the transparent conductive film (22).

**4.** The process according to any of the preceding claims, wherein at least one of the first dielectric film or the third dielectric film include silicon oxide or magnesium fluoride.

**5.** The process according to any of the preceding claims, wherein the third dielectric film includes a metal oxide, a metal nitride, or a metal oxinitride.

**6.** The process according to any of the preceding claims, wherein the third dielectric film is deposited by direct sputtering of dielectric material.

**7.** A deposition apparatus (100) for manufacturing a transparent body (10) for use in a touch panel, said apparatus comprising:
a first deposition assembly (102) configured to deposit a first transparent layer stack (12) over a substrate (14), said first transparent layer stack (12) including a first dielectric film (16), a second dielectric film (18) and a third dielectric film (20), the first and the third dielectric films having a refractive index lower than 1.5 and the second dielectric film having a refractive index of at least 1.8; and
a second deposition assembly (104) configured to deposit a transparent conductive film (22),
wherein said first deposition assembly (102) and said second deposition assembly (104) are arranged such that the first transparent layer stack (12) and the transparent conductive film (22) are disposed over the substrate (14) in this order, and
at least one of the first deposition assembly (102) or the second deposition assembly comprises a sputtering system (120, 123, 125, 127) operatively coupled to a rotatable target (122, 124, 126, 128, 322, 324, 326, 328), said sputtering system being configured to deposit at least one of the first dielectric film (16), the second dielectric film (18), the third dielectric film (20), or the transparent conductive film (22) by sputtering of the rotatable target.

**8.** The apparatus according to claim 7, wherein the first deposition assembly (102) is configured to deposit the first dielectric film (16), the second dielectric film (18), and the third dielectric film (20) over the substrate in this order.

**9.** The apparatus according to any of claims 7 to 8, wherein the first deposition assembly (102) and the second deposition assembly (104) are configured for depositing the first transparent stack (12) and the transparent conductive film (22) by magnetron sputtering.

**10.** The apparatus according to any of claims 7 to 9, further
comprising a measurement system (138) configured for measuring during deposition optical properties of at least one of the films forming part of at least one of the first layer stack or the transparent conductive film.

**11.** The apparatus according to any of claims 7 to 10, wherein the first deposition assembly (102) is configured for depositing the third dielectric film (20) by direct sputtering of dielectric material.

**12.** The apparatus according to any of claims 7 to 11, wherein the first deposition assembly (102) and the second deposition assembly (104) include a plurality of rotatable targets (122, 124, 126, 128, 122, 324, 326, 328) configured in a manner such that the first dielectric film (16), the second dielectric film (20), the third dielectric film (18), and the transparent conductive film (22) can be deposited by sputtering of the rotatable targets.

**13.** A transparent body (10) produced by the process according to any of claims 1 to 6, comprising:
a first transparent layer stack (12) over a substrate (14), said first transparent layer stack (12) including a first dielectric film (16), a second dielectric film (18), a third dielectric film (20) and a transparent conductive film (22),
wherein the first transparent layer stack (12) and the transparent conductive film (22) are disposed over the substrate (14) in this order and the first and the third dielectric films having a refractive index lower than 1.5 and the second dielectric film having a refractive index of at least 1.8, and
**characterised in that** at least one of the first dielectric film (16), the second dielectric film (18), the third dielectric film (20), or the transparent conductive film (22) is deposited by sputtering of a rotatable target (122, 124, 126, 128, 322, 324, 326, 328).

**14.** A touch panel comprising a transparent body (10) according to claim 13.

## Amended claims

### Amended claims in accordance with Rule 137(2) EPC.

**1.** A process for manufacturing a transparent body (10) for use in a touch panel, the process comprising:
depositing a first transparent layer stack (12) over a substrate (14), said first transparent layer stack (12) including a first dielectric film (16), a second dielectric film (18), and a third dielectric film (20), the first and the third dielectric films having a refractive index lower than 1.5 and the second dielectric film having a refractive index of at least 1.8; and
depositing a transparent conductive film (22) in a manner such that the first transparent layer stack (12) and the transparent conductive film (22) are disposed over the substrate (14) in this order;
**characterized in that** at least one of the first dielectric film (16), the second dielectric film (18), or the third dielectric film (20) is deposited by sputtering of a rotatable target (122, 124, 126, 128, 322, 324, 326).

**2.** The process according to claim 1, wherein the first dielectric film (16), the second dielectric film (18), and the third dielectric film (20) are disposed over the substrate in this order.

**3.** The process according to any of the preceding claims, further comprising patterning the transparent conductive film (22).

**4.** The process according to any of the preceding claims, wherein at least one of the first dielectric film or the third dielectric film include silicon oxide or magnesium fluoride.

**5.** The process according to any of the preceding claims, wherein the third dielectric film includes a metal oxide, a metal nitride, or a metal oxinitride.

**6.** The process according to any of the preceding claims, wherein the third dielectric film is deposited by direct sputtering of dielectric material.

**7.** A deposition apparatus (100) for manufacturing a transparent body (10) for use in a touch panel, said apparatus comprising:
a first deposition assembly (102) configured to deposit a first transparent layer stack (12) over a substrate (14), said first transparent layer stack (12) including a first dielectric film (16), a second dielectric film (18) and a third dielectric film (20), the first and the third dielectric films having a refractive index lower than 1.5 and the second dielectric film having a refractive index of at least 1.8; and
a second deposition assembly (104) configured to deposit a transparent conductive film (22),
wherein said first deposition assembly (102) and said second deposition assembly (104) are arranged such that the first transparent layer stack (12) and the transparent conductive film (22) are disposed over the substrate (14) in this order, and
at least one of the first deposition assembly (102) or the second deposition assembly comprises a sputtering system (120, 123, 125) operatively coupled to a rotatable target (122, 124, 126, 128, 322, 324, 326), said sputtering system being configured to deposit at least one of the first dielectric film (16), the second dielectric film (18), or the third dielectric film (20) by sputtering of the rotatable target.

**8.** The apparatus according to claim 7, wherein the first deposition assembly (102) is configured to deposit the first dielectric film (16), the second dielectric film (18), and the third dielectric film (20) over the substrate in this order.

**9.** The apparatus according to any of claims 7 to 8, wherein the first deposition assembly (102) and the second deposition assembly (104) are configured for depositing the first transparent stack (12) and the transparent conductive film (22) by magnetron sputtering.

**10.** The apparatus according to any of claims 7 to 9, further comprising a measurement system (138) configured for measuring during deposition optical properties of at least one of the films forming part of at least one of the first layer stack or the transparent conductive film.

**11.** The apparatus according to any of claims 7 to 10, wherein the first deposition assembly (102) is configured for depositing the third dielectric film (20) by direct sputtering of dielectric material.

**12.** The apparatus according to any of claims 7 to 11, wherein the first deposition assembly (102) and the second deposition assembly (104) include a plurality of rotatable targets (122, 124, 126, 128, 122, 324, 326) configured in a manner such that the first dielectric film (16), the second dielectric film (20), the third dielectric film (18), and the transparent conductive film (22) can be deposited by sputtering of the rotatable targets.

**13.** A transparent body (10) produced by the process according to any of claims 1 to 6, comprising:
a first transparent layer stack (12) over a substrate (14), said first transparent layer stack (12) including a first dielectric film (16), a second dielectric film (18), a third dielectric film (20) and a transparent conductive film (22),
wherein the first transparent layer stack (12) and the transparent conductive film (22) are disposed over the substrate (14) in this order and the first and the third dielectric films having a refractive index lower than 1.5 and the second dielectric film having a refractive index of at least 1.8, and
**characterised in that** at least one of the first dielectric film (16), the second dielectric film (18), or the third dielectric film (20) is deposited by sputtering of a rotatable target (122, 124, 126, 128, 322, 324, 326).

**14.** A touch panel comprising a transparent body (10) according to claim 13.

## Amended claims

### Amended claims in accordance with Rule 137(2) EPC.

**1.** A process for manufacturing a transparent body (10) for use in a touch panel, the process comprising:
depositing a first transparent layer stack (12) over a substrate (14), said first transparent layer stack (12) including a first dielectric film (16), a second dielectric film (18), and a third dielectric film (20), the first and the third dielectric films having a refractive index lower than 1.5 and the second dielectric film having a refractive index of at least 1.8; and
depositing a transparent conductive film (22) in a manner such that the first transparent layer stack (12) and the transparent conductive film (22) are disposed over the substrate (14) in this order;
**characterized in that** at least one of the first dielectric film (16), the second dielectric film (18), the third dielectric film (20), or the transparent conductive film (22) is deposited by sputtering of a rotatable target (122, 124, 126, 128, 322, 324, 326, 328).

**2.** The process according to claim 1, wherein the first dielectric film (16), the second dielectric film (18), and the third dielectric film (20) are disposed over the substrate in this order.

**3.** The process according to any of the preceding claims, further comprising patterning the transparent conductive film (22).

**4.** The process according to any of the preceding claims, wherein at least one of the first dielectric film or the third dielectric film include silicon oxide or magnesium fluoride.

**5.** The process according to any of the preceding claims, wherein the third dielectric film includes a metal oxide, a metal nitride, or a metal oxinitride.

**6.** The process according to any of the preceding claims, wherein the third dielectric film is deposited by direct sputtering of dielectric material.

**7.** A deposition apparatus (100) for manufacturing a transparent body (10) for use in a touch panel, said apparatus comprising:
a first deposition assembly (102) configured to deposit a first transparent layer stack (12) over a substrate (14), said first transparent layer stack (12) including a first dielectric film (16), a second dielectric film (18) and a third dielectric film (20), the first and the third dielectric films having a refractive index lower than 1.5 and the second dielectric film having a refractive index of at least 1.8; and
a second deposition assembly (104) configured to deposit a transparent conductive film (22),
wherein said first deposition assembly (102) and said second deposition assembly (104) are arranged such that the first transparent layer stack (12) and the transparent conductive film (22) are disposed over the substrate (14) in this order, and
at least one of the first deposition assembly (102) or the second deposition assembly comprises a sputtering system (120, 123, 125, 127) operatively coupled to a rotatable target (122, 124, 126, 128, 322, 324, 326, 328), said sputtering system being configured to deposit at least one of the first dielectric film (16), the second dielectric film (18), the third dielectric film (20), or the transparent conductive film (22) by sputtering of the rotatable target.

**8.** The apparatus according to claim 7, wherein the first deposition assembly (102) is configured to deposit the first dielectric film (16), the second dielectric film (18), and the third dielectric film (20) over the substrate in this order.

**9.** The apparatus according to any of claims 7 to 8, wherein the first deposition assembly (102) and the second deposition assembly (104) are configured for depositing the first transparent stack (12) and the transparent conductive film (22) by magnetron sputtering.

**10.** The apparatus according to any of claims 7 to 9, further comprising a measurement system (138) configured for measuring during deposition optical properties of at least one of the films forming part of at least one of the first layer stack or the transparent conductive film.

**11.** The apparatus according to any of claims 7 to 10, wherein the first deposition assembly (102) is configured for depositing the third dielectric film (20) by direct sputtering of dielectric material.

**12.** The apparatus according to any of claims 7 to 11, wherein the first deposition assembly (102) and the second deposition assembly (104) include a plurality of rotatable targets (122, 124, 126, 128, 122, 324, 326, 328) configured in a manner such that the first dielectric film (16), the second dielectric film (20), the third dielectric film (18), and the transparent conductive film (22) can be deposited by sputtering of the rotatable targets.

## Amended claims

### Amended claims in accordance with Rule 137(2) EPC.

**1.** A process for manufacturing a transparent body (10) for use in a touch panel, the process comprising:
depositing a first transparent layer stack (12) over a substrate (14), said first transparent layer stack (12) including a first dielectric film (16), a second dielectric film (18), and a third dielectric film (20), the first and the third dielectric films having a refractive index lower than 1.5 and the second dielectric film having a refractive index of at least 1.8; and
depositing a transparent conductive film (22) in a manner such that the first transparent layer stack (12) and the transparent conductive film (22) are disposed over the substrate (14) in this order;
**characterized in that** at least one of the first dielectric film (16), the second dielectric film (18), or the third dielectric film (20) is deposited by sputtering of a rotatable target (122, 124, 126, 128, 322, 324, 326).

**2.** The process according to claim 1, wherein the first dielectric film (16), the second dielectric film (18), and the third dielectric film (20) are disposed over the substrate in this order.

**3.** The process according to any of the preceding claims, further comprising patterning the transparent conductive film (22).

**4.** The process according to any of the preceding claims, wherein at least one of the first dielectric film or the third dielectric film include silicon oxide or magnesium fluoride.

**5.** The process according to any of the preceding claims, wherein the third dielectric film includes a metal oxide, a metal nitride, or a metal oxinitride.

**6.** The process according to any of the preceding claims, wherein the third dielectric film is deposited by direct sputtering of dielectric material.

**7.** A deposition apparatus (100) for manufacturing a transparent body (10) for use in a touch panel, said apparatus comprising:
a first deposition assembly (102) configured to deposit a first transparent layer stack (12) over a substrate (14), said first transparent layer stack (12) including a first dielectric film (16), a second dielectric film (18) and a third dielectric film (20), the first and the third dielectric films having a refractive index lower than 1.5 and the second dielectric film having a refractive index of at least 1.8; and
a second deposition assembly (104) configured to deposit a transparent conductive film (22),
wherein said first deposition assembly (102) and said second deposition assembly (104) are arranged such that the first transparent layer stack (12) and the transparent conductive film (22) are disposed over the substrate (14) in this order, and
at least one of the first deposition assembly (102) or the second deposition assembly comprises a sputtering system (120, 123, 125) operatively coupled to a rotatable target (122, 124, 126, 128, 322, 324, 326), said sputtering system being configured to deposit at least one of the first dielectric film (16), the second dielectric film (18), or the third dielectric film (20) by sputtering of the rotatable target.

**8.** The apparatus according to claim 7, wherein the first deposition assembly (102) is configured to deposit the first dielectric film (16), the second dielectric film (18), and the third dielectric film (20) over the substrate in this order.

**9.** The apparatus according to any of claims 7 to 8, wherein the first deposition assembly (102) and the second deposition assembly (104) are configured for depositing the first transparent stack (12) and the transparent conductive film (22) by magnetron sputtering.

**10.** The apparatus according to any of claims 7 to 9, further comprising a measurement system (138) configured for measuring during deposition optical properties of at least one of the films forming part of at least one of the first layer stack or the transparent conductive film.

**11.** The apparatus according to any of claims 7 to 10, wherein the first deposition assembly (102) is configured for depositing the third dielectric film (20) by direct sputtering of dielectric material.

**12.** The apparatus according to any of claims 7 to 11, wherein the first deposition assembly (102) and the second deposition assembly (104) include a plurality of rotatable targets (122, 124, 126, 128, 122, 324, 326) configured in a manner such that the first dielectric film (16), the second dielectric film (20), the third dielectric film (18), and the transparent conductive film (22) can be deposited by sputtering of the rotatable targets.
